# EUROPEAN PATENT SPECIFICATION

(11) **EP 1 478 090 B1**
(45) Date of publication and mention of the grant of the patent: **05.12.2012**
(21) Application number: 04011347.4
(22) Date of filing: 13.05.2004
(51) Int. Cl.: H03H 9/21, H03H 9/10

(54) **Tuning-fork-type piezoelectric resonator element**
Piezoelektrisches Stimmgabel-Resonatorbauelement
Elément résonateur piézo-électrique du type à diapason

(30) Priority: 16.05.2003 JP 2003139208
(43) Date of publication of application: 17.11.2004
(73) Proprietor: Seiko Epson Corporation, Shinjuku-ku Tokyo 163-0811 (JP)
(72) Inventor: Yamada, Yoshiyuki, Suwa-shi Nagano-ken 392-8502 (JP)
(74) Representative: MERH-IP Matias Erny Reichl Hoffmann

(56) References cited:
- JP-A- 1 311 712
- JP-A- 56 000 737
- JP-A- 57 185 717
- PATENT ABSTRACTS OF JAPAN vol. 005, no. 125 (E-069), 12 August 1981 (1981-08-12) & JP 56 061820 A (MATSUSHIMA KOGYO CO LTD; others: 01), 27 May 1981 (1981-05-27)

## Description

The present invention relates to a tuning-fork-type piezoelectric resonator element and a tuning-fork-type piezoelectric resonator.

A piezoelectric resonator, particularly, a tuning-fork-type piezoelectric resonator is known as a piezoelectric resonator that can be employed to obtain an accurate clock frequency simply and easily. Recent demand to miniaturize and thin electronic devices also requires a tuning-fork-type piezoelectric resonator to be miniaturized and thinned. To meet such a demand, a surface mounting type tuning-fork-type piezoelectric resonator has been developed. Such type of resonator is mounted so that the surface of a tuning-fork-type piezoelectric resonator element is made parallel to the bottom face of a package, and is mounted at the bottom face of the package in the form of a cantilever.

JP-A-2001-332952 discloses a tuning-fork-type piezoelectric resonator having a resonator element mounted in the form of a cantilever in a package that includes a package base and a cover. A concave portion having a rectangular shape in plan view is provided at the package base adjacent to resonating arms of the resonator element. The provision of the concave portion below the free end of the resonator element prevents contact with the package base, even when the resonator element vibrates greatly due to an external shock. As a result, the resonator is not deformed and the frequency characteristics are prevented from being changed.

JP-A-01-311712 discloses a tuning-fork-type piezoelectric resonator element according to the precharacterizing portion of claim 1.

In JP-A-56-61820, a frame is provided at a tuning-fork-type piezoelectric resonator element to surround the element body on all four sides. The resonator element is interposed between two packages, which are joined to each other and sealed by a metal material. The joining and sealing are made with the frame protruding beyond the package. The protruding part of the frame functions to prevent the metal material provided at upper and lower sides of the frame from being shortcircuited.

In the conventional tuning-fork-type piezoelectric resonator, the resonator element is mounted via a base in the form of a cantilever. Therefore, the parallelism of the resonator element relative to the package is poor, and the resonator element is in fact slantingly mounted in the package. Therefore, the conventional resonator has the problem that its resonating arms may come into contact with the bottom face of the package or the cover, thereby stopping oscillation.

Moreover, in the conventional resonator described in JP-A-2001-332952, in order to prevent the resonating arms from contacting the bottom face of the package, the concave portion is formed at the bottom face of the package. The concave portion should have enough depth to positively prevent the contact of the resonating arms with the package, and thus, it becomes difficult to make the resonator sufficiently thin. Furthermore, a base from which resonating arms of the tuning-fork-type piezoelectric resonator protrude is mounted on the package base, causing the problem of increase of vibration leakage and crystal impedance (Cl) value.

Furthermore, in the conventional tuning-fork-type piezoelectric resonator described in JP-A-56-61820, when two electrodes of the resonator element and a package-side mounting electrode are electrically connected to one another by a conductive adhesive, the two electrodes of the resonator element and the package-side mounting electrode approach each other. Thus, the conductive adhesive may overflow, causing short-circuiting between the electrodes.

The present invention has been made to solve the above-mentioned problems, and it is an object of the present invention to provide a tuning-fork-type piezoelectric resonator element capable of being mounted in a package in parallel therewith. It is another object of the present invention to provide a tuning-fork-type piezoelectric resonator that can be made thinner than conventional ones by using the resonator element.

This object is achieved by a tuning-fork-type piezoelectric resonator element as claimed in claim 1. Preferred embodiments of the invention are subject-matter of the dependent claims.

Since the support of the resonator element is formed along an end of the base and the one long side of the element body, the resonator element has a smaller outside dimension than the conventional resonator elements surrounded by a frame on all four sides. As a result, the size of a package for mounting the resonator element therein can be reduced. Further, a mount is provided at the short leg and at a tip of the long leg to be joined to a package. The mounts allow the piezoelectric resonator element to be horizontally mounted on the bottom face of the package.

Hereinafter, preferred embodiments of the present invention will be explained in detail with reference to the drawings, in which:
- Fig. 1: is a plan view of a tuning-fork-type piezoelectric resonator according to a first embodiment;
- Fig. 2: is a cross-sectional view of the tuning-fork-type piezoelectric resonator according to the first embodiment;
- Fig. 3: illustrates the number of resonator elements according to the first embodiment from a piezoelectric wafer;
- Fig. 4: is a plan view of a tuning-fork-type piezoelectric resonator element according to a second embodiment;
- Fig. 5: illustrates the number of resonator elements according to the second embodiment of the present invention obtained from a piezoelectric wafer;
- Fig. 6: shows a modified example of the resonator element according to the second embodiment; and
- Fig. 7: illustrates various tuning-fork-type piezoelectric resonator elements according to a third embodiment.

### First Embodiment

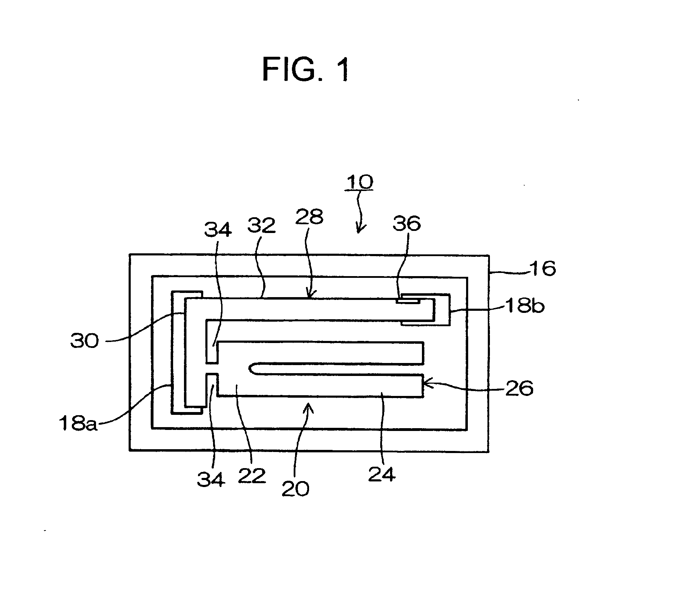

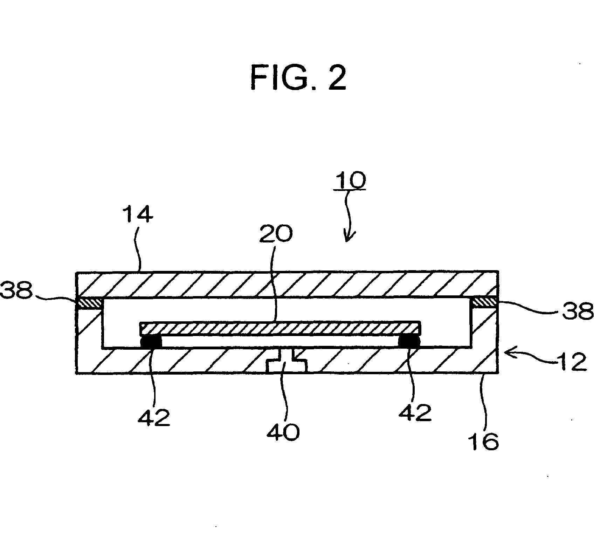

First, a first embodiment of the present invention will be described. Fig. 1 is a plan view of a tuning-fork-type piezoelectric resonator 10, and Fig. 2 is a cross-sectional view of the resonator 10. The resonator 10 has a tuning-fork-type piezoelectric resonator element 20 mounted inside a package 12 composed of a base 16 whose upper part is hermetically sealed with a cover 14.

The resonator element 20 includes a reed or element body 26 and a support 28. The element body 26 includes a base 22 and resonating arms 24 extending from one end of the base 22. The support 28 has an L shape with a short leg 30 extending along the other end of the base 22 and a long leg 32 extending from one end of the short leg 30 along a long side of the element body 26. The short leg 30 is connected to the other end of the base 22. The width of the connecting part becomes narrow by a pair of grooves 34 formed at both sides thereof so that the vibration leak of the piezoelectric resonator element body 26 is reduced.

Connection electrodes (not shown) are provided at the bottom face of the short leg 30 and at the bottom face on the tip of the long leg 32, respectively, so that they are electrically connected to excitation electrodes (not shown) formed at the resonating arms 24. The connection electrodes function as a mount when they are mounted in the package 12. Moreover, a mounting alignment pattern 36 is formed at the long leg 32. The mounting alignment pattern 36 is provided to improve positioning accuracy when the resonator element 20 is mounted in the package 12. Like the excitation electrodes themselves, the mounting alignment pattern 36 is formed of a metal thin film or the like.
The package 12 has a box-like shape and is composed of the base 16 and the cover 14. The cover 14 formed of glass, ceramic or metal is joined to the package base 16 formed of a ceramic insulating substrate or the like via a sealing portion 38 made of low-melting glass. Package-side mounting electrodes 18a and 18b are formed inside the package base 16 so as to mount the resonator element 20. The mounting electrodes 18a and 18b are formed corresponding to the connection electrodes on the short leg 30 and the long leg 32 of the resonator element 20. Particularly, the mounting electrode 18b corresponding to the connection electrode of the long leg 32 is formed only under the long leg 32, but is not formed under the resonating arms 24. Accordingly, the resonator element 20 oscillates without the resonating arms 24 being brought into contact with the mounting electrode 18b. A sealing hole 40 is provided at the bottom of the package base 16 and is used when the package 12 is sealed under vacuum. When mounting the resonator element 20 in the package 12, the connection electrodes provided at the short leg 30 and the long leg 32 and the mounting electrodes 18a and 18b are bonded to each other by a conductive adhesive 42.

According to the above-mentioned embodiment, since the resonator element 20 is mounted by bonding the connection electrodes formed at the short and long legs 30 and 32 to the mounting electrodes 18a and 18b, it can be horizontally mounted on the bottom face of the package 12. Therefore, the clearance or gap between the resonator element 20 and the bottom face of the package base 16 can be reduced compared with what is required in the prior art, without danger that the resonating arms 24 come into contact with the cover 14 or the bottom face of the package base 16 when the resonator element 20 oscillates. Further, it is not necessary to provide the conventionally required concave portion in the package base 16. Accordingly, it is possible to make the resonator 10 thinner than is possible in the prior art.

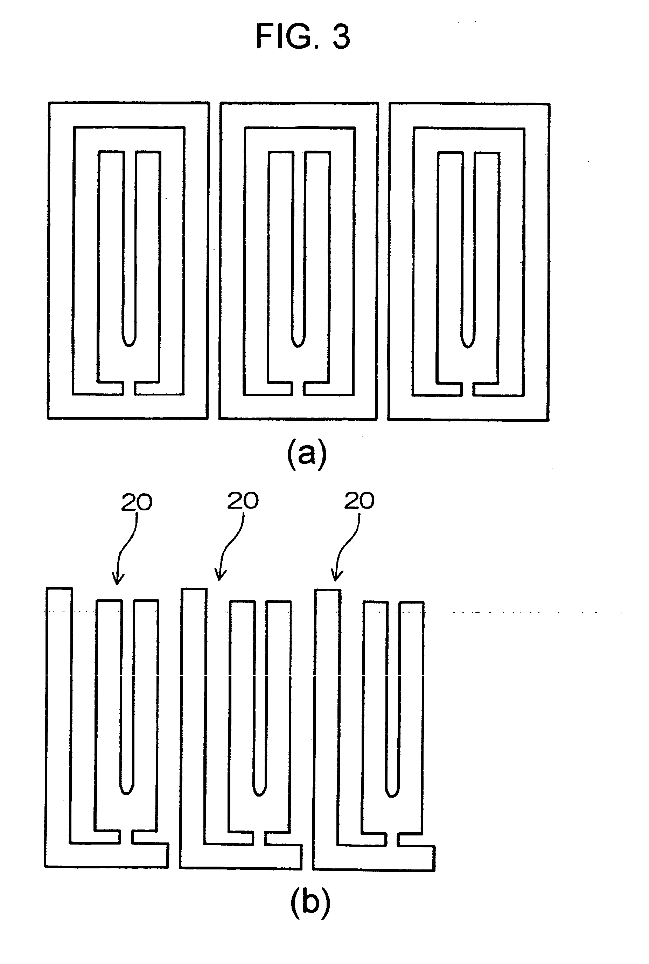

Further, the resonator element 20 having an L-shaped support 28 has a smaller outside dimension than that of conventional tuning-fork-type piezoelectric resonator elements that are surrounded by a frame on all four sides. Therefore, the package 12 for mounting the resonator element 20 therein can be miniaturized. Moreover, because the resonator element 20 has a smaller outside dimension than conventional ones, the number of resonator elements 20 obtained from one piezoelectric wafer, can be increased as is illustrated in Fig. 3.

Fig. 3(a) shows a pattern of tuning-fork-type piezoelectric resonator elements, surrounded by a frame on all four sides, on a piezoelectric wafer. Fig. 3(b) shows the pattern of resonator elements 20, having the L-shaped support 28, on a piezoelectric wafer. When the resonator elements are patterned at equal intervals and the obtained number of conventional resonator elements is 100, the obtained number of resonator elements 20 each having the support 28 becomes 145. As a result, 45% more resonator elements according to the invention than the conventional resonator elements can be obtained from one piezoelectric wafer.

### Second Embodiment

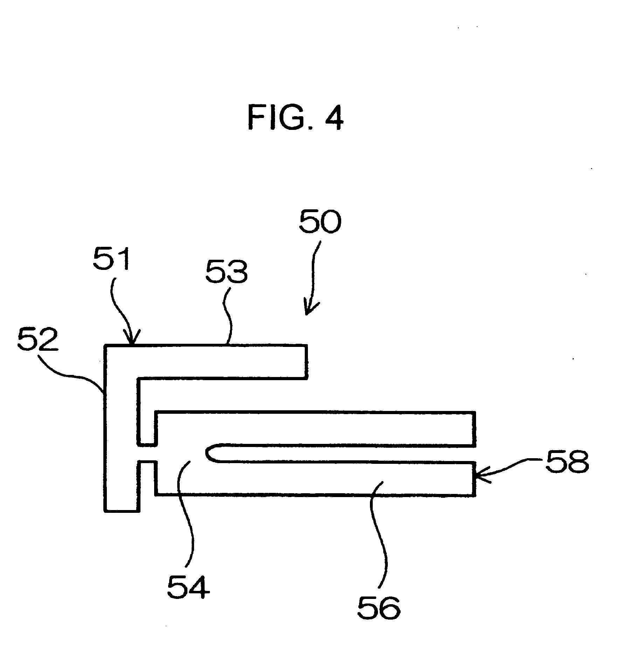

Next, a tuning-fork-type piezoelectric resonator element 50 according to a second embodiment will be described. Fig. 4 is a plan view of the resonator element 50 which is the same as the resonator element 20 according to the first embodiment except for the length of the long leg 53 being different from that of the long leg 32.

The resonator element 50 includes a reed or element body 58 having resonating arms 56 extending from one end of a base 54, and a support 51 having a short leg 52 that extends along the other end of the base 54 and the long leg 53 extending from one end of the short leg 52 along a long side of the element body 58. The long leg 53 is shorter than the long side of the element body 58, and, for example, the length of the long leg 53 is half that of the long side of the element body 58.

Connection electrodes (not shown) are provided at the bottom face of the short leg 52 and at the bottom face on the tip of the long leg 53, respectively. The connection electrodes function as a mount when they are mounted in a package.

Moreover, a mounting alignment pattern may be formed at the long leg 53 of the resonator element 50.

Since the resonator element 50 is bonded to the inside of a package through the mount (i.e., the connection electrodes), it can be horizontally mounted on the bottom face of the package. Therefore, the clearance or gap between the resonator element 50 and the bottom face of the package base can be reduced compared with what is required in the prior art, without danger that the resonating arms 56 come into contact with the cover or the bottom face of the package base when the resonator element 20 oscillates. Further, it is not necessary to provide the conventional concave portion in the package base. Accordingly, it is possible to make the tuning-fork-type piezoelectric resonator thinner than is possible in the prior art. Moreover, the resonator element 50 has a smaller outside dimension than the conventional tuning-fork-type piezoelectric resonator elements that are surrounded by a frame on all four sides. Therefore, the package for mounting the resonator element 50 can be miniaturized.

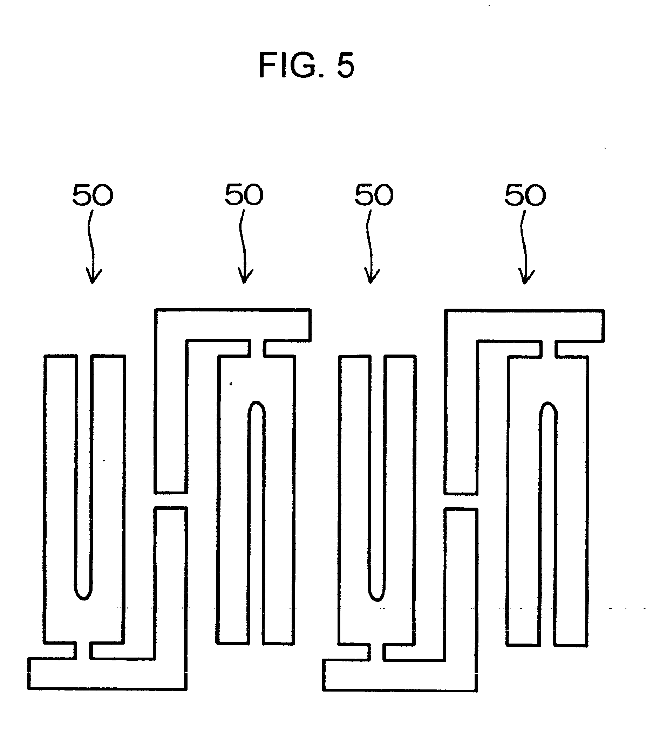

Further, the support 51 of the resonator element 50 has a smaller outside dimension because it is provided along the base 54 and a part of the long leg of the element body 58. Therefore, the number of resonator elements 50 obtained from one piezoelectric wafer can be increased as is illustrated in Fig. 5. When a pattern is formed by alternately arranging the resonator elements 50 on the piezoelectric wafer in the manner shown, the number of resonator elements 50 obtainable from one piezoelectric wafer becomes 177% that of the conventional resonator elements surrounded by a frame on all four sides. As a result, 77% more resonator elements 50 than the conventional resonator elements are obtained from one piezoelectric wafer.

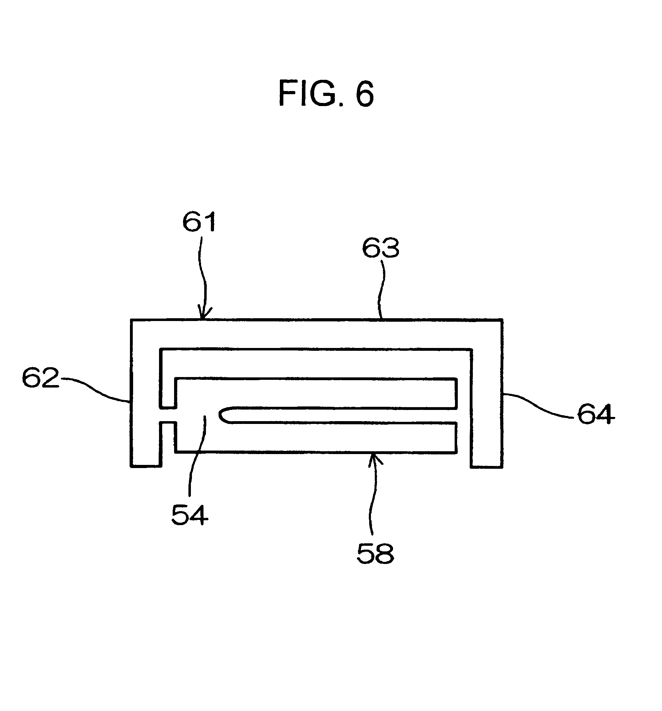

As an alternative to the above-described shape of the support 51, a support 61 may be provided along both short sides and one long side of the element body 58 as is shown in Fig. 6 which is a plan view of a tuning-fork-type piezoelectric resonator element having a support 61. The support 61 includes a first short leg 62 formed along the base 54, a second short leg 64 provided opposite the first short leg 62 and parallel thereto with the element body in between, and a long leg 63 that connects the two short legs 62 and 64 and extends along a long side of the element body 58. The long leg 63 and the two short legs 62 and 64 form U shape.

The same effects as those of the first embodiment can be obtained with this structure. That is, when a tuning-fork-type piezoelectric resonator element is mounted in a package, it can be horizontally mounted on the bottom face of the package, which allows a smaller clearance or gap between the resonator element 20 and the bottom face of the package. Accordingly, it is possible to make the tuning-fork-type piezoelectric resonator thinner than those of the prior art. Moreover, it is possible to decrease the outside dimension of the tuning-fork-type piezoelectric resonator element as compared with the conventional tuning-fork-type piezoelectric resonator element surrounded by a frame on all four sides.

### Third Embodiment

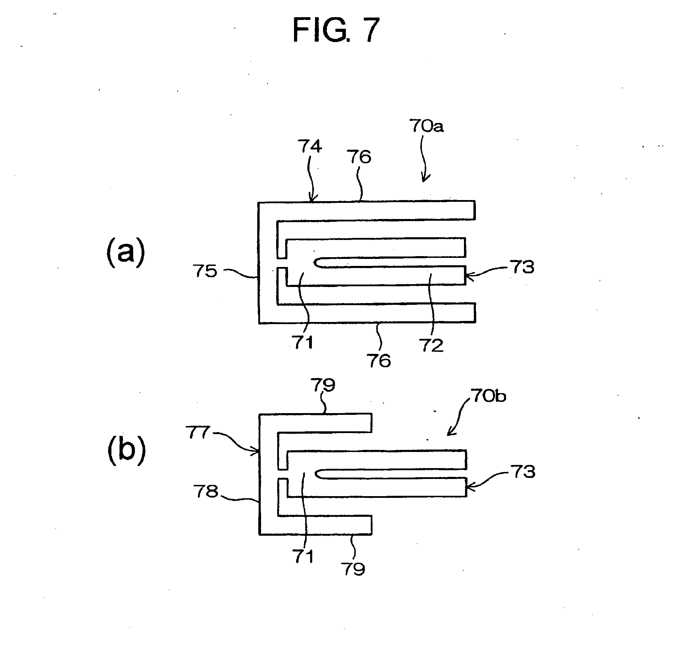

Next, a third embodiment will be described. Fig. 7(a) and 7(b) illustrate tuning-fork-type piezoelectric resonator elements according to this third embodiment that differ in the structure of the respective supports.

As shown in Fig. 7(a), the element body 73 of the resonator element 70a includes resonating arms 72 extending from one end of a base 71. A support 74 includes a short leg 75 along the other end of the base 71, and long legs 76 extending from both ends of the short leg 75 in the longitudinal direction of the element body 73. Further, as shown in Fig. 7(b), the resonator element 70b includes an element body 73 and a support 77. The support 77 includes a short leg 78 along the other end of the base 71, and long legs 79 extending from both ends of the short leg 78 in the longitudinal direction of the element body 73. Each of the long legs 79 is shorter than a long side of the element body 73. For example, the length of each long leg 79 is half that of the long leg of the element body 73. When the resonator elements 70a and 70b are mounted in a package, the bottom faces of the short legs 75 and 78, and the bottom faces at both ends of the two long legs 76 and 79 are joined to the package by a conductive adhesive, so that the resonator elements 70a and 70b can be mounted in a package while being kept horizontal to the bottom face of the package.

## Claims

1. A tuning-fork-type piezoelectric resonator element comprising:
an element body (26) including a base (22) and resonating arms (24) extending from one end of the base; and
a support (28) including a short leg (30) which is connected to the base (22) and extends along the other end of the base, and a long leg (32) extending from one end of the short leg along at least part of the length of one of said resonating arms (24); and
mounts provided at the tip of the long leg (32) and at the tip of the short leg (30).
**characterized in that**
the short leg (30) of the support (28) is connected to the base (22) by a connecting part whose width is narrower than that of the short leg (30) and the base (22) and which is defined by two grooves (34) formed on both sides between the short leg (30) and the base (22).

2. The resonator element according to Claim 1, wherein the long leg (53) is shorter than the element body (58).

3. The resonator element according to Claim 1, wherein the support (61) comprises said long leg (63) and two short legs (62, 64) one extending from each of the two opposite ends of the long leg so as to form a U-shape.

4. The resonator element according to Claim 1, wherein another long leg (76; 79) extends from the other end of the short leg (75; 78) along at least part of the length of another one of said resonating arms (24) such that the element body (83) is in between the two long legs (76; 79).

5. A tuning-fork-type piezoelectric resonator comprising: the resonator element according to any one of Claims 1 to 4, which is mounted on the bottom of a box-like open package by the mounts; and a cover (14) joined to and closing the open side of the package.

## Patentansprüche

1. Piezoelektrisches Stimmgabel-Resonatorbauelement mit:
einem Bauelementkörper (26) einschließlich einer Basis (22) und Resonanzarmen (24), die sich von einem Ende der Basis erstrecken; und
einer Auflage (28) einschließlich eines kurzen Schenkels (30), der mit der Basis (22) verbunden ist und sich entlang des anderen Endes der Basis erstreckt, und eines kurzen Schenkels (32), der sich von einem Ende des kurzen Schenkels entlang zumindest eines Teils der Länge von einem der Resonanzarme (24) erstreckt; und
Halterungen, die an der Spitze des langen Schenkels (32) und an der Spitze des kurzen Schenkels (30) vorgesehen sind,
**dadurch gekennzeichnet, dass**
der kurze Schenkel (30) der Auflage (28) mit der Basis (22) durch ein Verbindungsteil verbunden ist, dessen Breite schmaler als diejenige des kurzen Schenkels (30) und der Basis (22) ist und das durch zwei Nuten (34) begrenzt ist, die auf beiden Seiten zwischen dem kurzen Schenkel (30) und der Basis (22) ausgebildet sind.

2. Resonatorbauelement nach Anspruch 1, wobei der lange Schenkel (53) kürzer als der Bauelementkörper (58) ist.

3. Resonatorbauelement nach Anspruch 1, wobei die Auflage (61) den langen Schenkel (63) und zwei kurze Schenkel (62, 64) umfasst, wobei sich jeweils einer von jedem der beiden entgegengesetzten Enden des langen Schenkels erstreckt, so dass sie eine U-Form bilden.

4. Resonatorbauelement nach Anspruch 1, wobei sich ein weiterer langer Schenkel (76; 79) von dem anderen Ende des kurzen Schenkels (75; 78) entlang zumindest eines Teils der Länge eines anderen der Resonanzarme (24) erstreckt, so dass sich der Bauelementkörper (83) zwischen den zwei langen Schenkeln (76; 79) befindet.

5. Piezoelektrisches Stimmgabel-Resonatorbauelement mit: dem Resonatorbauelement nach irgendeinem der Ansprüche 1 bis 4, das durch die Halterungen am Boden eines schachtelartigen offenen Gehäuses angebracht ist; und einer Abdeckung (14), die mit der offenen Seite des Gehäuses verbunden ist und sie verschließt.

## Revendications

1. Elément résonateur piézoélectrique du type à diapason comprenant :
- un corps d'élément (26) comprenant une base (22) et des bras de résonance (24) s'étendant à partir d'une extrémité de la base ; et
- un support (28) comprenant une branche courte (30) qui est reliée à la base (22) et s'étend le long de l'autre extrémité de la base, et une branche longue (32) s'étendant à partir d'une extrémité de la branche courte le long d'au moins une partie de la longueur de l'un desdits bras de résonance (24) ; et
- des montures disposées à la pointe de la branche longue (32) et à la pointe de la branche courte (30) ;
**caractérisé par le fait que** :
- la branche courte (30) du support (28) est reliée à la base (22) par une partie de liaison dont la largeur est plus étroite que celle de la branche courte (30) et de la base (22) et qui est définie par deux rainures (34) formées sur les deux côtés entre la branche courte (30) et la base (22).

2. Elément résonateur selon la revendication 1, dans lequel la branche longue (53) est plus courte que le corps d'élément (58).

3. Elément résonateur selon la revendication 1, dans lequel le support (61) comprend ladite branche longue (63) et deux branches courtes (62, 64), l'une s'étendant à partir de chacune des deux extrémités opposées de la branche longue de façon à former une forme de U.

4. Elément résonateur selon la revendication 1, dans lequel une autre branche longue (76 ; 79) s'étend à partir de l'autre extrémité de la branche courte (75 ; 78) le long d'au moins une partie de la longueur d'un autre bras de résonance parmi lesdits bras de résonance (24) de telle sorte que le corps d'élément (83) se situe entre les deux branches longues (76 ; 79).

5. Résonateur piézoélectrique du type à diapason comprenant : l'élément résonateur selon l'une quelconque des revendications 1 à 4, qui est monté sur la partie inférieure d'un boîtier ouvert de type boîte par les montures ; et un couvercle (14) assemblé au et fermant le côté ouvert de l'emballage.
